# EUROPÄISCHE PATENTSCHRIFT

(11) **EP 0 329 077 B1**
(45) Veröffentlichungstag und Bekanntmachung des Hinweises auf die Patenterteilung: **17.08.1994**
(21) Anmeldenummer: 89102513.2
(22) Anmeldetag: 14.02.1989
(51) Int. Cl.: H03D 9/06, H03C 1/60, H03C 7/02

(54) **Einseitenbandmischer in Microstriptechnik**
SSB mixer in microstrip fashion
Mélangeur à bande latérale unique selon une technique à micro-bande

(30) Priorität: 17.02.1988 DE 3804926
(43) Veröffentlichungstag der Anmeldung: 23.08.1989
(73) Patentinhaber: SIEMENS AKTIENGESELLSCHAFT, 80333 München (DE)
(72) Erfinder: Sedlmair, Siegfried, Dipl.-Ing., D-8919 Utting (DE)

(56) Entgegenhaltungen:
- DE-A- 2 454 058
- GB-A- 2 110 025
- IEEE TRANSACTIONS ON MICROWAVE THEORY AND TECHNIQUES, Band MTT-30, Nr. 3, März1982, Seiten 227-234, IEEE, New York, US; H. OGAWA et al.: "Integrated balancedBPSK and QPSK modulators for the KA-Band"

## Beschreibung

Einseitenbandmischer für den Mikrowellenbereich, bestehend aus zwei Gegentaktmischern mit jeweils einem Diodenpaar, die mit 90° Phasenunterschied in den Oszillatoranschlüssen und in den Zwischenfrequenzanschlüssen betrieben werden und aufgebaut sind in gedruckter Schaltungstechnik derart, daß auf der metallisierten Seite eines einseitig ganzflächig metallisierten isolierenden Substrats die Signalanschlüsse mittels Schlitzleitungen erfolgen. Ein solcher Einseitenbandmischer ist aus IEEE TRANSACTIONS ON MICORWAVE THEORY AND TECHNIQUES, Band MTT-30, Nr. 3, März 1982, Seiten 227-234, IEEE, New York, US; H. OGAWA et al.: "Integrated balanced BPSK and QPSK modulars for the KA-Band" bekannt.

In der GB-A-2 110 025 ist ein Gegentaktmischer offenbart, der nach demselben Prinzip arbeitet wie der Gegentaktmischer im vorstehend beschriebenen Mischer.

Eine entsprechende Mischeranordnung ist beispielsweise auch aus dem Sonderheft "Nachrichtenübertragung auf Funkwegen" von telcom report 9 (1986) bekannt, in dem auf den Seiten 177 bis 180 ein Sende- und Empfangsumsetzer für breitbandige Digitalrichtfunksysteme beschrieben ist.

Ferner ist in der DE-AS 24 54 058 ein Ringmodulator beschrieben, der einen ähnlichen Aufbau aufweist.

Prinzipiell sind alle Nebenwellen aus Mischern unerwünscht. Folgt dem Mischer ein Verstärker wie z.B. bei Richtfunksendern, so wird dieser auch durch die Nebenwellen ausgesteuert und eine Leistungsanzeige oder -regelung wird irregeführt. Außerdem sinkt die Aussteuerungsfähigkeit für das Nutzsignal. Die erste Oszillatoroberwelle ist bei Einseitenbandmischern, die die Oszillatorgrundwelle und das unerwünschte Seitenband in der üblichen Weise gut unterdrücken, das stärkste Störungssignal.

Zur Unterdrückung der Oberwelle lassen sich beispielsweise Tiefpässe oder Sperrkreise im Mischerausgang verwenden, die entweder auf dem Mischersubstrat oder in Koaxialtechnik außerhalb des Mischers eingeschaltet werden. Beides bringt jedoch Probleme mit sich. Microstripsperren wirken nämlich bei höheren Frequenzen immer weniger, da derart hohe Frequenzen (Oszillatoroberwelle als doppelte Oszillatorfrequenz) teilweise als Oberflächenwellen laufen und Microstripfilter überspringen. Die mögliche Nachschaltung eines Tiefpasses in Koaxial- oder Hohlleitertechnik ist sehr aufwendig.

Der Erfindung liegt die Aufgabe zugrunde, eine Lösung anzugeben, mit der die Ausbreitung unerwünschter Frequenzen in einfacher Weise unterbunden wird.

Diese Aufgabe wird mit einem Einseitenbandmischer der eingangs beschriebenen Art gemäß einer ersten Ausführungsform in der Weise gelöst, daß bei einer, bezogen auf eine T-Verzweigung antiparallelen Anordnung der Diodenpaare in jeweils gleichpoliger Reihenschaltung in den beiden Gegentaktmischern die Schlitzleitungen zu der T-Verzweigung zusammengeführt sind, daß die T-Verzweigung der Schlitzleitungen zu einem Magischen-T (Differential-Brückenschaltung) erweitert ist durch eine auf der Substratgegenseite die Schlitzleitungen im Bereich der T-Verzweigung kreuzende und etwa λ/4 der ersten Oszillatoroberwelle in Richtung der Abzweigung überstehende Microstipleitung, die in ihrem anderen Endbereich mit einem ohmschen Widerstand abgeschlossen ist, dem die als gleichphasige Signale ausgekoppelte erste Oszillatoroberwelle und das nicht benutzte Seitenband zugeführt werden.

Eine weitere erfindungsgemäße Ausführungsform ist in Anspruch 5 angegeben.

Bei allen erfindungsgemäßen Ausführungsformen erfolgt eine solche Zusammenschaltung der beiden, den Einseitenbandmischer bildenden Gegentaktmischer, daß sich die ersten Oszillatoroberwellen entweder auslöschen oder mittels eines Magischen-T auf einen Abschlußwiderstand geführt werden. Die Unterdrückung der unerwünschten ersten Oszillatoroberwelle erfolgt dabei breitbandig und kostengünstig.

Nachstehend wird die Erfindung anhand von in der Zeichnung dargestellten Ausführungsbeispielen näher erläutert.

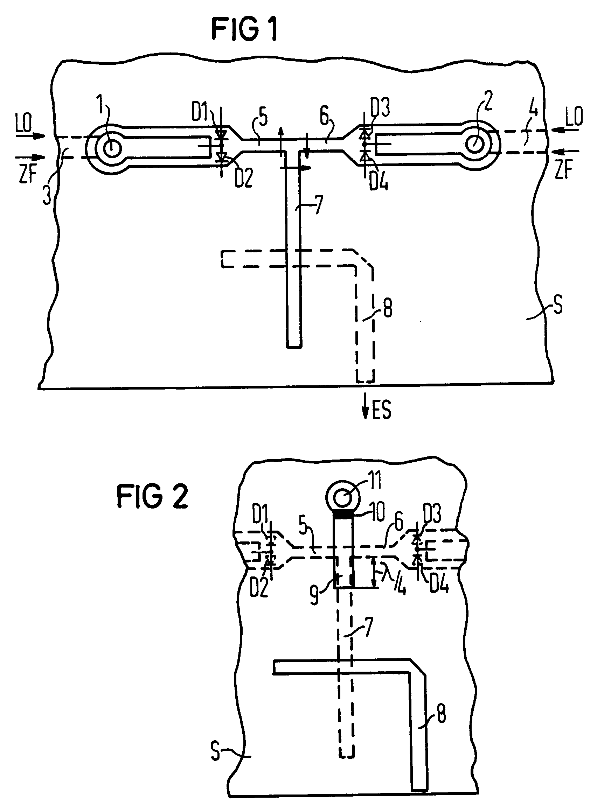

Die Figuren 1 bis 6 zeigen jeweils in einer Teildarstellung die Zusammenschaltung der beiden Gegentaktmischer mit unterschiedlicher Auskopplung der Signale.

Figur 1 zeigt einen Einseitenbandmischer aus zwei Gegentaktmischern mit Auskopplung der gegenphasigen Signale. Es werden hierbei zwei Diodenpärchen D1, D2 und D3, D4 mit gleicher Diodenpolung verwendet. Untersuchungen haben gezeigt, daß die entstehenden ersten Oberwellen des Oszillators der beiden Gegentaktmischer eines Einseitenbandmischers mit gleichen Diodenpärchen in Gleichphase sind. Diese Oberwellen gelangen also über parallel geschaltete Signalanschlüsse zum Ausgang. Um das zu verhindern, ist der Signalausgang für die Auskopplung gegenphasiger Signale aus den beiden Gegentaktmischern zu gestalten; dann heben sich die ersten Oberwellen des Oszillators auf. Als Nutzsignal werden dann die gegenphasigen Seitenbänder ausgekoppelt.

Eine solche Gestaltung des Signalausgangs, wodurch sich gleichphasige Signale aufheben und die gegenphasigen Seitenbänder ausgekoppelt werden und die erste Oszillatoroberwelle nicht zum Signalausgang gelangt, ist in Figur 1 realisiert. Diese zeigt die Anordnung in Planartechnik auf Keramiksubstrat, wobei die Metallisierung auf der in der Figur oben liegenden Seite des Substrats S aufgebracht ist. Die beiden Gegentaktmischer mit den gleichen Diodenpärchen D1, D2 und D3, D4 sind in Koplanarleitungstechnik ausgeführt. Die Oszillator- und ZF-Versorgung erfolgt über Durchkontaktierungen 1 und 2 von der anderen Seite des Substrats S über Microstripleitungen 3 und 4, je 90° phasenverschoben. Die in den Dioden D1 bis D4 erzeugten Mischprodukte gelangen über Schlitzleitungen 5,6 zu einer T-Verzweigung, deren abzweigende Schlitzleitung mit 7 bezeichnet ist. Nur gegenphasige Signale gelangen in die Schlitzleitung 7 und werden über eine kreuzende Microstripleitung 8 auf der anderen Substratseite zum Signalausgang geführt, dem das Einseitenbandsignal ES entnehmbar ist.

Während es sich also bei der Anordnung nach Fig. 1 um einen Einseitenbandmischer mit Reflexion der ersten Oszillatoroberwelle handelte, zeigt Fig. 2 einen Einseitenbandmischer mit Abschlußwiderstand für die erste Oszillatoroberwelle. Die Zusammenschaltung der beiden Gegentaktmischer mit Oszillator- und ZF-Versorgung erfolgt in der gleichen Weise wie bei der Anordnung nach Fig. 1, jedoch mit getrennter Auskopplung und Abdämpfung der gleichphasigen Oszillatoroberwellen. Bei dieser Anordnung, die einen Blick auf die Microstripseite des Substrats S zeigt, ist die einfache T-Verzweigung der Schlitzleitungen 5 und 6 zu einem "Magischen-T" (Differenzial-Brückenschaltung) erweitert, so daß man die gleichphasigen Signale, also die erste Oszillatoroberwelle und das andere nicht benützte Seitenband auskoppeln und z. B. einem Abschlußwiderstand zuführen kann. Das ergibt einen gleichmäßigen, ruhigeren Frequenzgang der Mischverluste im Vergleich zu einer Anordnung, bei der die gleichphasigen Signale zu den Mischern reflektiert und rückgemischt werden. Diese Ausführungsform ist daher sehr vorteilhaft. Es werden hierbei die gleichphasigen Signale der ersten Oszillatoroberwelle durch eine auf der Substratgegenseite (Microstripseite) die Schlitzleitungen 5,6 im Bereich der T-Verzweigung kreuzende und etwa λ/4 der ersten Oszillatoroberwelle überstehende Microstripleitung 9 ausgekoppelt und einem im anderen Endbereich der Microstripleitung 7 liegenden Widerstand zugeführt. Dieser liegt über eine Durchkontaktierung 11 wiederum an Masse. Die Auskopplung wirkt für die gleichphasigen Seitenbänder nicht hundertprozentig, da die überstehende Microstripleitung für diese Frequenz nicht exakt λ/4 ist. Die gegenphasigen Seitenbänder (Nutzsignal) sind dadurch jedoch nicht berührt und gelangen weiterhin in die abzweigende Schlitzleitung 7 und über die kreuzende Microstripleitung 8 auf der andern Substratseite zum Signalausgang.

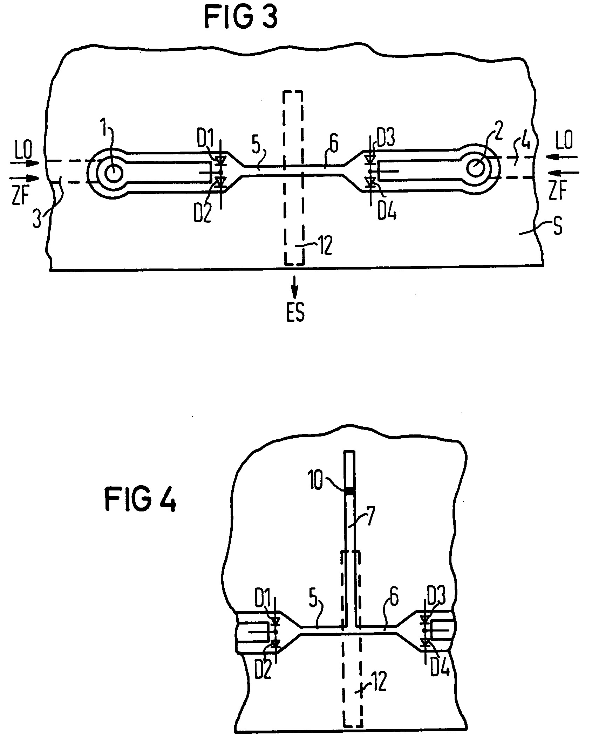

Fig. 3 zeigt einen Einseitenbandmischer als Zusammenschaltung von zwei Gegentaktmischern mit den Dioden D1, D2 und D3, D4, wobei in einem der beiden Gegentaktmischer eine umgekehrte Diodenpolung (D3,D4) vorgesehen ist. Die ersten Oszillatoroberwellen der beiden Gegentaktmischer sind jetzt in Gegenphase, es wird daher eine gleichphasige Signalauskopplung vorgenommen. Diese erfolgt durch eine auf der Gegenseite (in der Figur unten liegende Seite des Substrats) die Schlitzleitungen 5,6 kreuzende Microstripleitung 12, deren Ausgang das Einseitenbandsignal ES entnehmbar ist.

Fig. 4 zeigt einen Einseitenbandmischer aus der Zusammenschaltung von zwei Gegentaktmischern wie in Fig. 3, also mit umgekehrter Polung der Dioden in einem der beiden Mischer. Hierbei erfolgt jedoch eine getrennte Auskopplung und Abdämpfung der gegenphasigen Oszillatoroberwellen. Die Auskoppelstelle ist wiederum zu einem "Magischen-T" erweitert, wobei die gegenphasigen Signale in die abzweigende Schlitzleitung 7 laufen, die etwa λ/4 für die erste Oszillatoroberwelle von ihrem Ende entfernt einen Abschlußwiderstand 10 enthält. In diesen Abschlußwiderstand gelangt auch ein Großteil des unbenützten Seitenbandes, so daß auch hier ein gleichmäßiger Frequenzgang des Mischverlustes erreicht wird. Das Einseitenbandsignal ES ist der auf der Gegenseite die Schlitzleitungen 5,6 kreuzenden Microstripleitung 12 (auf der in der Figur unten liegenden Substratseite) entnehmbar.

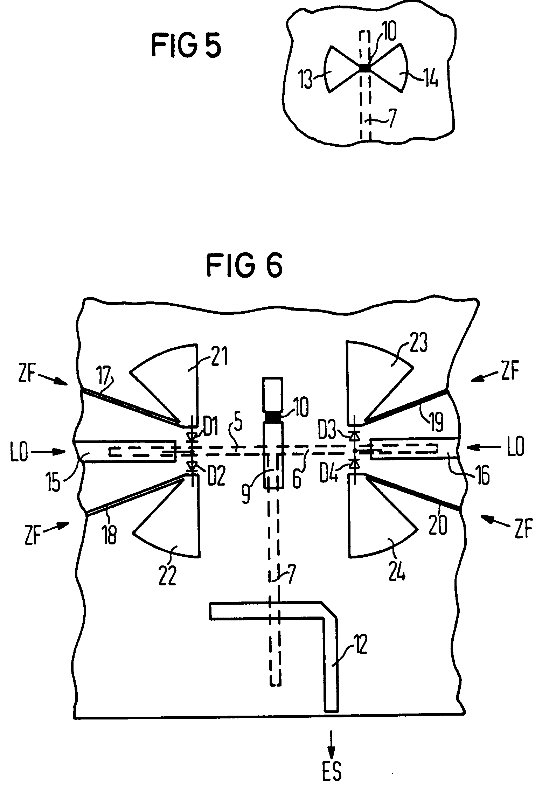

Der Abschlußwiderstand 10 kann auch in einer die abzweigende Schlitzleitung 7 kreuzenden Microstripleitung auf der anderen Substratseite liegen. Fig. 5 zeigt hierzu eine Detaildarstellung der Anordnung mit bei der doppelten Oszillatorfrequenz ca. λ/4 langen leerlaufenden Radialstubs 13,14.

Fig. 6 zeigt einen Einseitenbandmischer als Zusammenschaltung von zwei Gegentaktmischern, deren Dioden D1 bis D4 auf der Microstripseite (in der Figur oben liegende Seite des Substrats) angeordnet sind. Die Oszillator- und ZF-Versorgung der Dioden erfolgt über separate Microstripleitungen 15,16 und 17 bis 20, wobei im Anschlußbereich der ZF-Versorgung Kreissegmente 21 bis 24 als RF-Kurzschluß vorgesehen sind. Die Auskoppelstelle aus der einfachen T-Verzweigung der Schlitzleitungen 5,6 und 7 ist auch hierbei zu einem "Magischen-T" erweitert. Die gleichphasigen Signale der ersten Oszillatoroberwelle werden dabei durch die auf der Substratgegenseite die Schlitzleitungen 5,6 kreuzenden und etwa λ/4 der ersten Oszillatoroberwelle überstehende Microstripleitung 9 ausgekoppelt und dem Widerstand 10 zugeführt. Die gegenphasigen Seitenbänder gelangen in die abzweigende Schlitzleitung 7 der T-Verzweigung und werden über die kreuzende Microstripleitung 12 auf der anderen Substratseite zum Signalausgang geführt.

Wie eingangs bereits ausgeführt wurde, wirkt sich das Auftreten der ersten Oszillatoroberwelle besonders im Sendezweig eines Richtfunkgerätes störend aus, während diese Oberwelle im Empfangszweig wenig stört. Die vorstehend beschriebenen Ausführungsbeispiele befassen sich daher im wesentlichen mit Sendemischern, d. h. Aufwärtsumsetzern. Selbstverständlich sind aber diese erfindungsgemäßen Maßnahmen auch bei Empfangsmischern anwendbar.

## Patentansprüche

1. Einseitenbandmischer für den Mikrowellenbereich, bestehend aus zwei Gegentaktmischern mit jeweils einem Diodenpaar (D1, D2; D3, D4), die mit 90° Phasenunterschied in den Oszillatoranschlüssen und in den Zwischenfrequenzanschlüssen betrieben werden und aufgebaut sind in gedruckter Schaltungstechnik derart, daß auf der metallisierten Seite eines einseitig ganzflächig metallisierten isolierenden Substrats (S) die Signalanschlüsse mittels Schlitzleitungen erfolgen, dadurch **gekennzeichnet**, daß bei einer, bezogen auf eine T-Verzweigung antiparallelen Anordnung der Diodenpaare in jeweils gleichpoliger Reihenschaltung in den beiden Gegentaktmischern die Schlitzleitungen (5, 6) zu der T-Verzweigung zusammengeführt sind, daß die T-Verzweigung der Schlitzleitungen zu einem Magischen-T (Differential-Brückenschaltung) erweitert ist durch eine auf der Substratgegenseite die Schlitzleitungen im Bereich der T-Verzweigung kreuzende und etwa λ/4 der ersten Oszillatoroberwelle in Richtung der Abzweigung überstehende Microstripleitung (9), die in ihrem anderen Endbereich mit einem ohmschen Widerstand (10) abgeschlossen ist, dem die als gleichphasige Signale ausgekoppelte erste Oszillatoroberwelle und das nicht benutzte Seitenband zugeführt werden.

2. Einseitenbandmischer nach Anspruch 1, dadurch **gekennzeichnet**, daß ein Anschluß des ohmschen Widerstandes (10) über eine Durchkontaktierung (11) an Masse liegt.

3. Einseitenbandmischer nach Anspruch 1, dadurch **gekennzeichnet**, daß ein Anschluß des ohmschen Widerstandes (10) in eine etwa λ/4 der ersten Oszillatoroberwelle lange Leitung führt.

4. Einseitenbandmischer nach Anspruch 1, dadurch **gekennzeichnet**, daß die beiden Diodenpaare (D1, D2; D3, D4) auf der Microstripseite angeordnet sind, auf der für jede Diode jeweils Microstripleitungen (15-20) für die Oszillator- und Zwischenfrequenzanschlüsse und Kreissegmente (21-24) als RF-Kurzschluß vorgesehen sind.

5. Einseitenbandmischer für den Mikrowellenbereich, bestehend aus zwei Gegentaktmischern mit jeweils einem Diodenpaar (D1, D2; D3, D4), die mit 90° Phasenunterschied in den Oszillatoranschlüssen und in den Zwischenfrequenzanschlüssen betrieben werden und aufgebaut sind in gedruckter Schaltungstechnik derart, daß auf der metallisierten Seite eines einseitig ganzflächig metallisierten isolierenden Substrats (S) die Signalanschlüsse mittels Schlitzleitungen erfolgen, dadurch **gekennzeichnet**, daß bei einer, bezogen auf eine T-Verzweigung parallelen Anordnung der Diodenpaare in jeweils gleichpoliger Reihenschaltung in den beiden Gegentaktmischern die Schlitzleitungen (5, 6) zu einer T-Verzweigung zusammengeführt sind, daß die T-Verzweigung der Schlitzleitungen zu einem Magischen-T erweitert ist durch eine auf der Substratgegenseite die Schlitzleitungen im Bereich der T-Verzweigung kreuzende Microstripleitung (12), und daß die abzweigende Schlitzleitung (7), in der die gegenphasigen Signale laufen, etwa λ/4 für die erste Oszillatoroberwelle von ihrem Ende entfernt einen Abschlußwiderstand (10) enthält zur Aufnahme eines Großteils des unbenützten Seitenbandes.

6. Einseitenbandmischer nach Anspruch 5, dadurch **gekennzeichnet**, daß der Abschlußwiderstand (10) in einer die abzweigende Schlitzleitung (7) kreuzenden Microstipleitung auf der anderen Substratseite liegt.

## Claims

1. Single-sideband mixer for the microwave range, consisting of two push-pull mixers having in each case one pair of diodes (D1, D2; D3, D4) which are operated with 90° phase difference in the oscillator connections and in the intermediate-frequency connections and are constructed in printed circuit technology, in such a manner that the signals are connected by means of slotted lines on the metallized side of an insulating substrate (S) which is metallized over its whole area on one side, characterized in that in an antiparallel arrangement of the pairs of diodes with respect to a T branch, in each case in identically polarized series circuit in the two push-pull mixers, the slotted lines (5, 6) are brought together to form the T branch, and in that the T branch of the slotted lines is expanded to form a magic-T (differential bridge circuit) by means of a microstrip line (9), which crosses the slotted lines in the area of the T branch on the opposite side of the substrate and projects in the direction of the branch by about λ/4 of the first oscillator harmonic, which microstrip line is terminated in its other end region by means of an non-reactive resistor (10) which is supplied with the first oscillator harmonic, extracted as in-phase signals, and the unused sideband.

2. Single-sideband mixer according to Claim 1, characterized in that one terminal of the non-reactive resistor (10) is connected to earth via a through-plated hole (11).

3. Single-sideband mixer according to Claim 1, characterized in that one terminal of the non-reactive resistor (10) leads into a line with a length of about λ/4 of the first oscillator harmonic.

4. Single-sideband mixer according to Claim 1, characterized in that the two pairs of diodes (D1, D2; D3, D4) are arranged on the side of the microstrip on which microstrip lines (15 - 20) for the oscillator and intermediate-frequency connections and circular segments (21 - 24) as RF short circuit are in each case provided for each diode.

5. Single-sideband mixer for the microwave range, consisting of two push-pull mixers having in each case one pair of diodes (D1, D2; D3, D4) which are operated with 90° phase difference in the oscillator connections and in the intermediate-frequency connections and are constructed in printed circuit technology, in such a manner that the signals are connected by means of slotted lines on the metallized side of an insulating substrate (S) which is metallized over its whole area on one side, characterized in that with a parallel arrangement of the pairs of diodes with respect to a T branch, in each case in identically polarized series connection in the two push-pull mixers, the slotted lines (5, 6) are brought together to form a T branch, in that the T branch of the slotted lines is expanded to form a magic-T by means of a microstrip line (12), crossing the slotted lines in the area of the T branch on the opposite side of the substrate, and in that the branching slotted line (7), in which the out-of-phase signals are conducted, contains a terminator resistor (10) for accommodating a large proportion of the unused sideband approximately λ/4 for the first oscillator harmonic away from its end.

6. Single-sideband mixer according to Claim 5, characterized in that the terminator resistor (10) is located in a microstrip line crossing the branching slotted line (7) on the other side of the substrate.

## Revendications

1. Mélangeur à bande latérale unique pour le domaine des micro-ondes, constitué de deux mélangeurs symétriques, comportant chacun un couple de diodes (D1; D2; D3; D4), qui fonctionnent avec une différence de phase de 90° aux bornes de l'oscillateur et aux bornes à fréquence intermédiaire et qui sont agencées selon la technique des circuits imprimés de sorte que les bornes de transmission de signaux sont constituées de lignes à fente sur la face métallisée d'un substrat isolant (S), entièrement métallisé sur l'une de ses faces, caractérisé par le fait que dans le cas d'un montage antiparallèle, rapporté à un embranchement en T, des couples de diodes dans un circuit série respectivement de même polarité, dans les deux mélangeurs symétriques, les lignes à fente (5, 6) sont réunies en l'embranchement en T, que l'embranchement en T des lignes à fente est élargi en un T magique (circuit en pont différentiel) par une ligne à microruban (9), qui, sur la face opposée du substrat, croise les lignes à fente dans la zone de l'embranchement en T et fait saillie en direction de la dérivation, sur environ λ/4 du premier harmonique de l'oscillateur et qui se termine, à son autre zone d'extrémité, par une résistance ohmique (10), à laquelle sont envoyées le premier harmonique de l'oscillateur, qui est découplé sous la forme de signaux en phase, et la bande latérale non utilisée.

2. Mélangeur à bande latérale unique suivant la revendication 1, caractérisé par le fait qu'une borne de la résistance ohmique (10) est mise à la masse par l'intermédiaire d'un contact traversant (11).

3. Mélangeur à bande latérale unique suivant la revendication 1, caractérisé par le fait qu'une borne de la résistance ohmique (10) se prolonge par une ligne d'une longueur égale à environ λ/4 du premier harmonique de l'oscillateur.

4. Mélangeur à bande latérale unique suivant la revendication 1, caractérisé par le fait que les deux couples de diodes (D1, D2; D3, D4) sont disposés sur la face, sur laquelle, pour chaque diode, il est prévu respectivement des lignes à microruban (15 à 20) pour les bornes de l'oscillateur et à fréquence intermédiaire et des segments circulaires (21 à 24) en tant que court-circuit HF.

5. Mélangeur à bande latérale unique pour la gamme des micro-ondes, constitué de deux mélangeurs symétriques, comportant chacun un couple de diodes (D1; D2; D3; D4) qui fonctionnent avec une différence de phase de 90° aux bornes de l'oscillateur et aux bornes à fréquence intermédiaire et qui sont agencées selon la technique des circuits imprimés de sorte que les bornes de transmission de signaux sont constituées par des lignes à fente, sur la face métallisée d'un substrat isolant (S), entièrement métallisé sur l'une de ses faces, caractérisé par le fait que dans le cas d'un montage parallèle, rapporté à un embranchement en T, des couples de diodes dans un circuit série respectivement de même polarité, dans les deux mélangeurs symétriques, les lignes à fente (5, 6) sont réunies en l'embranchement en T, que l'embranchement en T des lignes à fente est élargi en un T magique, par une ligne à microruban (12), qui croise, sur la face opposée du substrat, les lignes à fente dans la zone de l'embranchement en T, et que la ligne à fente de dérivation (7), dans laquelle passent les signaux en opposition de phase, comporte, à une distance de son extrémité égale à environ λ/4 du premier harmonique de l'oscillateur, une résistance de terminaison (10) destinée à recevoir une grande partie de la bande latérale non utilisée.

6. Mélangeur à bande latérale unique suivant la revendication 5, caractérisé par le fait que la résistance de terminaison (10) est dans une ligne à microruban, qui croise la ligne à fente de dérivation (7), sur l'autre face du substrat.
